(19) **Europäisches Patentamt / European Patent Office / Office européen des brevets**

(11) **EP 4 145 165 B1**

(12) **EUROPÄISCHE PATENTSCHRIFT**

(45) Veröffentlichungstag und Bekanntmachung des Hinweises auf die Patenterteilung:
**17.07.2024   Patentblatt 2024/29**

(21) Anmeldenummer: **21194854.2**

(22) Anmeldetag: **03.09.2021**

(51) Internationale Patentklassifikation (IPC):
**G01R 33/565** (2006.01)   G01R 33/561 (2006.01)
**G01R 33/48** (2006.01)   G01R 33/28 (2006.01)

(52) Gemeinsame Patentklassifikation (CPC):
**G01R 33/56581**; G01R 33/288; G01R 33/4828;
**G01R 33/5617**

(54) **ANSTEUERUNG EINES MAGNETRESONANZGERÄTES MIT KOMPENSIERTER MAXWELL-PHASE**

CONTROL OF A MAGNETIC RESONANCE DEVICE WITH COMPENSATED MAXWELL PHASE

COMMANDE D'UN APPAREIL À RÉSONANCE MAGNÉTIQUE À PHASE MAXWELL COMPENSÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**08.03.2023   Patentblatt 2023/10**

(73) Patentinhaber: **Siemens Healthineers AG**
**91301 Forchheim (DE)**

(72) Erfinder:
• **Zeller, Mario**
**91054 Erlangen (DE)**
• **Zhou, Kun**
**Shenzhen, 518057 (CN)**
• **Paul, Dominik**
**91088 Bubenreuth (DE)**

(74) Vertreter: **Siemens Healthineers**
**Patent Attorneys**
**Postfach 22 16 34**
**80506 München (DE)**

(56) Entgegenhaltungen:
**US-B1- 6 512 372**

• **ZHOU X J ET AL: "ARTIFACTS INDUCED BY CONCOMITANT MAGNETIC FIELD IN FAST SPIN-ECHO IMAGING", MAGNETIC RESONANCE IN MEDICINE, WILEY-LISS, US, vol. 40, no. 4, 12 December 2005 (2005-12-12), pages 582 - 591, XP000781736, ISSN: 0740-3194**

**Beschreibung**

Die Erfindung betrifft ein Verfahren, ein Magnetresonanzgerät, ein Computerprogrammprodukt sowie einen elektronisch lesbaren Datenträger zu einer Ansteuerung eines Magnetresonanzgerätes mit Kompensation einer Maxwell-Phase.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 oder 7 Tesla, ausgesetzt. Zusätzlich werden mit Hilfe einer Gradientenspuleneinheit Gradientenpulse ausgespielt. Gradientenpulse werde durch elektrische Ansteuerung der Gradientenspuleneinheit erzeugt und bewirken einen Magnetfeldgradienten im Patientenaufnahmebereich. Über eine Hochfrequenzantenneneinheit werden dann mittels geeigneter Antenneneinrichtungen hochfrequente Hochfrequenz-Pulse (HF-Pulse), beispielsweise Anregungspulse, ausgesendet, was dazu führt, dass die Kernspins bestimmter, durch diese HF-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale (MR-Signale), abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Für eine bestimmte Messung ist daher eine bestimmte Magnetresonanz-Steuerungssequenz (MR-Steuerungssequenz), auch Pulssequenz genannt, auszusenden, welche aus einer Folge von HF-Pulsen, beispielsweise Anregungspulsen und Refokussierungspulsen, sowie passend dazu koordiniert auszusendenden Gradientenpulsen in verschiedenen Gradientenachsen entlang verschiedener Raumrichtungen besteht. Zeitlich passend hierzu werden Auslesefenster gesetzt, welche die Zeiträume vorgeben, in denen die induzierten MR-Signale erfasst werden. Beim Ausspielen einer MR-Steuerungssequenz treten Maxwell-Felder als Begleiterscheinung von Magnetfeldgradienten auf. Diese können zu Artefakten in den rekonstruierten Bilddaten führen, da sie Abweichungen zu den gewünschten Feldern darstellen. Dies ist beispielsweise in "Concomitant Gradient Terms in Phase Contrast MR: Analysis and Correction", Bernstein et al., MRM 39300-308 (1998), beschrieben. Der Artikel Zhou X. J. et al.: "Artifacts induced by concomitant magnetic field in fast spin-echo imaging", MRM, Bd. 40, Nr. 4, 1998, Seiten 582-591, analysiert Artefakte aufgrund von Phasenstörungen in mittels FSE-Sequenzen aufgenommener Bilddaten.

Der Erfindung liegt die Aufgabe zugrunde, ein Verfahren zu einer Ansteuerung eines Magnetresonanzgerätes anzugeben, durch Maxwell-Felder hervorgerufene Störungen besonders gut kompensiert. Die Aufgabe wird durch die Merkmale der unabhängigen Ansprüche gelöst. Vorteilhafte Ausgestaltungen sind in den Unteransprüchen beschrieben.

Das erfindungsgemäße Verfahren zu einer Ansteuerung eines Magnetresonanzgerätes gemäß einer MR-Steuerungssequenz sieht vor, dass die MR-Steuerungssequenz zumindest einen Anregungspuls gefolgt von zumindest zwei Refokussierungspulsen umfasst. Alle Magnetfeldgradienten wirkend auf einer Ausleseachse des Auslesegradienten und vorgesehen zwischen genau zwei der zumindest zwei konsekutiven Refokussierungspulse induzieren eine erste Maxwell-Phase. Zwischen genau zwei der zumindest zwei konsekutiven Refokussierungspulsen ist auch zumindest ein Auslesegradient vorgesehen. Die MR-Steuerungssequenz umfasst einen bipolaren Gradientenpuls aufweisend einen ersten Teil und zweiten Teil mit gegensätzlicher Polarität angeordnet zwischen dem Anregungspuls und einem ersten der zumindest zwei konsekutiven Refokussierungspulse,
wobei

- eine Maxwell-Phase induziert durch den bipolaren Gradientenpuls zwischen 40% und 60% der ersten Maxwell-Phase entspricht,
- ein Gradientenmoment des bipolaren Gradientenpulses einem Dephasiergradientenmoment für den Auslesegradient entspricht, und
- eine Dauer des bipolaren Gradientenpulses höchstens einem ersten zeitlichen Abstand zwischen Anregungspuls und einem ersten der zumindest zwei konsekutiven Refokussierungspulse entspricht.

Ein Anregungspuls ist typischerweise ein HF-Puls, welcher dazu ausgebildet ist, einen Spin initial aus dessen Gleichgewichtsposition zu verkippen. Ein Anregungspuls induziert typischerweise einen definierten Flipwinkel von 90° oder weniger. Insbesondere in Kombination mit Spin-Echo basierten MR-Steuerungssequenzen induziert der Anregungspuls einen Flipwinkel vorzugsweise zwischen 80° und 92°, besonders bevorzugt einen Flipwinkel von 90°. Ein Anregungspuls verkippt eine mittlere Drehachse einer Menge an Spins, definiert durch deren mittlere Gleichgewichtsposition um den definierten Flipwinkel vorzugsweise in eine zu mittleren Gleichgewichtsposition senkrechte Ebene.

Ein Refokussierungspuls ist typischerweise ein HF-Puls, welcher dazu ausgebildet ist, eine Rephasierung einer dephasierenden Menge an Spins zu initiieren. Eine Menge an Spins unterliegt in der zur mittleren Gleichgewichtsposition senkrechten Ebene typischerweise einer Dephasierung. Insbesondere in Kombination mit Spin-Echo basierten, bevorzugt einer Turbo-Spin-Echo (TSE) basierten MR-Steuerungssequenzen induziert der Refokussierungspuls einen Flipwinkel typischerweise zwischen 100° und 182°, bevorzugt einen Flipwinkel zwischen 120° und 180°, besonders bevorzugt einen Flipwinkel von 180°. Ein Refokussierungspuls erzeugt ein Echo durch eine Rephasierung der dephasierenden Menge an Spins, wobei der Zeitpunkt des Echos durch den zeitlichen Abstand zwischen einem Anregungspuls und einem ersten Refokussierungspuls definiert ist, welcher zeitlicher Abstand im Folgenden als erster zeitlicher Abstand bezeichnet wird. Der erste zeitliche Abstand entspricht typischerweise der halben Echozeit einer Spin-Echo basierten, insbesondere auch einer TSE basierten MR-Steuerungssequenz. Die MR-Steuerungssequenz umfasst zumindest zwei konsekutive Refokussierungspulse folgend einem Anregungspuls. Folgend einem Anregungspuls werden demnach zumindest zwei Echos gebildet, welche jeweils MR-Signale aussenden. Die MR-Steuerungssequenz ist demnach typischerweise als TSE Sequenz ausgebildet. Der zeitliche Abstand zwischen zwei aufeinanderfolgenden Refokussierungspulsen der zumindest zwei konsekutiven Refokussierungspulse entspricht typischerweise der Echozeit.

Im Rahmen der Ortskodierung einer MR-Steuerungssequenz werden typischerweise Gradientenpulse entlang dreier verschiedener Raumrichtungen geschalten. Beim Ausspielen eines Gradientenpulses entlang einer Raumrichtung wird typischerweise ein Magnetfeldgradient in diese Raumrichtung erzeugt. Simultan zu den HF-Pulsen, insbesondere simultan zu dem Anregungspuls und/oder einem Refokussierungspuls, kann ein Gradientenpuls entlang einer Schichtselektionsachse ausgegeben werden, welcher Gradientenpuls einen Magnetfeldgradienten entlang der Schichtselektionsachse erzeugt. Nach einem Refokussierungspuls, insbesondere zu einem Zeitpunkt definiert durch den zweifachen ersten zeitlichen Abstand, also entsprechend der Echozeit, zu welcher eine Rephasierung der Menge der Spins erfolgt, kann ein Gradientenpuls entlang einer Ausleseachse ausgegeben werden, welcher Gradientenpuls einen Magnetfeldgradienten entlang der Ausleseachse erzeugt. Ein solcher Gradientenpuls kann als Auslesegradient bezeichnet werden. Nach einem Refokussierungspuls und vor einem Auslesegradienten kann ein Gradientenpuls entlang einer Phasenkodierachse ausgegeben werden, welcher Gradientenpuls einen Magnetfeldgradienten entlang der Phasenkodierachse erzeugt. Ein solcher Gradientenpuls kann als erster Phasenkodiergradient bezeichnet werden. Zusätzlich kann zwischen dem Auslesegradienten und einem zweiten Refokussierungspuls ein zum ersten Phasenkodiergradient inverser zweiter Phasenkodiergradient vorgesehen sein. Die Ausleseachse ist vorzugsweise senkrecht zur Phasenkodierachse und/oder zur Schichtselektionsachse. Gradientenpulse, insbesondere auch Magnetfeldgradienten entlang der voneinander verschiedenen Achsen können typischerweise unabhängig voneinander angesteuert werden.

HF-Pulse weisen typischerweise eine endliche, definierte Dauer auf, welche sich insbesondere durch eine Form der HF-Pulse und/oder einen zu erzielenden definierten Flipwinkel bestimmt. Der zeitliche Abstand zwischen zwei HF-Pulsen kann durch den zeitlichen Abstand zwischen einem Ende des ersten der zwei HF-Pulse und einem Beginn des zweiten der zwei HF-Pulse definiert sein. Der zeitliche Abstand zwischen zwei HF-Pulsen kann durch den zeitlichen Abstand zwischen dem zeitlichen Mittelpunkt des ersten der zwei HF-Pulse und dem zeitlichen Mittelpunkt des zweiten der zwei HF-Pulse definiert sein. Der zeitliche Abstand zwischen zwei HF-Pulsen kann durch den zeitlichen Abstand zwischen einem Ende des den ersten der zwei HF-Pulse begleitenden Schichtselektionsgradienten und einem Beginn des den zweiten der zwei HF-Pulse begleitenden Schichtselektionsgradienten definiert sein. Für den ersten zeitliche Abstand entspricht der erste HF-Puls der zwei HF-Pulse typischerweise dem Anregungspuls und der zweite HF-Puls der zwei HF-Pulse typischerweise dem ersten der zumindest zwei Refokussierungspulsen.

Der Auslesegradient erzeugt typischerweise eine Dephasierung während des Ausspielens des Auslesegradienten. Ein dem Auslesegradient vorgeschalteter und/oder nachgeschalteter Dephasiergradient ermöglicht ein Auslesen eines Echos einer gleichzeitig rephasierenden Menge an Spins und/oder ein symmetrisches Auslesen einer k-Raum-Zeile. Hierzu ist typischerweise ein Dephasiergradient wirkend auf der Ausleseachse zwischen Anregungspuls und erstem Refokussierungspuls vorgesehen, welcher ein Dephasiergradientenmoment aufweist. Das Dephasiergradientenmoment definiert das Gradientenmoment des Dephasiergradienten und entspricht typischerweise dem halben Gradientenmoment des Auslesegradienten. Ein Gradientenmoment ist typischerweise als Zeitintegral über den entsprechenden Magnetfeldgradienten definiert. Das Dephasiergradientenmoment entspricht demnach typischerweise der Hälfte des Zeitintegrals über den Auslesegradienten. Der Dephasiergradient ist typischerweise ein Gradientenpuls.

Eine Maxwell-Phase entspricht typischerweise einer Phase induziert durch ein Maxwell-Feld, das typischerweise als Begleiterscheinung von Magnetfeldgradienten auftritt. Das Maxwell-Feld kann durch

$$B_C(x,y,z,t) = \frac{1}{2\,B_0}\left[G_x^2\,z^2 + G_y^2\,z^2 + G_z^2\,\frac{x^2+y^2}{4} - G_x G_z xz - G_y G_z yz\right]$$

definiert sein, wobei $G_x$ einem Magnetfeldgradienten entlang der Ausleseachse entspricht, $G_y$ einem Magnetfeldgradienten entlang der Phasenkodierachse entspricht und $G_z$ einem Magnetfeldgradienten entlang der Schichtselektionsachse entspricht. Eine Maxwell-Phase ist typischerweise proportional zum Zeitintegral über $B_C(x,y,z,t)$ und entspricht typischerweise dem Zeitintegral über $B_C(x,y,z,t)$ multipliziert mit dem gyromagnetischen Verhältnis. Die erste Maxwell-Phase ist typischerweise bestimmt durch das Maxwell-Feld induziert durch alle auf der Ausleseachse wirkenden Magnetfeldgradienten zwischen zwei aufeinanderfolgenden Refokussierungspulsen der zumindest zwei konsekutiven Refokussierungspulse.

Die erste Maxwell-Phase ist vorzugsweise bestimmt durch das Maxwell-Feld zumindest erster Ordnung induziert durch die auf der Ausleseachse wirkenden Magnetfeldgradienten zwischen zwei aufeinanderfolgenden Refokussierungspulsen der zumindest zwei konsekutiven Refokussierungspulse. Die erste Maxwell-Phase kann durch das Maxwell-Feld proportional zum Quadrat des Auslesegradienten sein. Die erste Maxwell-Phase kann insbesondere Kreuzterme des Maxwell-Feldes umfassend ein Produkt von zwei Magnetfeldgradienten unterschiedlicher Gradientenachsen vernachlässigen.

Die Maxwell-Phase induziert durch den bipolaren Gradientenpuls, insbesondere durch den aus dem bipolaren Gradientenpuls resultierenden Magnetfeldgradienten, entspricht typischerweise zwischen 35% und 65%, bevorzugt zwischen 45% und 55%, besonders bevorzugt der Hälfte der ersten Maxwell-Phase. Die Maxwell-Phase des bipolaren Gradientenpulses entspricht vorzugsweise der Maxwell-Phase, welche zum Zeitpunkt des Echos aufgrund des Auslesegradienten induziert wird. Der Zeitpunkt des Echos entspricht typischerweise dem Zeitpunkt des maximalen MR-Signals und/oder ist definiert durch die Echozeit. Die Dephasierung aufgrund des Maxwell-Feldes induziert durch den Auslesegradienten zum Zeitpunkt des Echos, also typischerweise nach der Hälfte der Dauer des Auslesegradienten, entspricht typischerweise der halben ersten Maxwell-Phase.

Das erfindungsgemäße Verfahren ermöglicht durch die Verwendung des bipolaren Gradientenpulses eine für den Auslesegradienten erforderliche Dephasierung und eine gleichzeitige Kompensation der Maxwell-Felder. Der bipolare Gradientenpuls ist, wie auch der Auslesegradient, auf der Ausleseachse vorgesehen. Eine Maxwell-Phase ausgehend vom Auslesegradient und vom bipolaren Gradientenpuls weist hauptsächlich eine quadratische Abhängigkeit von den entsprechenden Magnetfeldgradienten auf. Der erste Teil und der zweite Teil des bipolaren Gradientenpulses tragen demnach unabhängig und gleichwertig zur vom bipolaren Gradientenpuls erzeugten Maxwell-Phase bei. Die lineare Abhängigkeit des Gradientenmomentes von einem Magnetfeldgradienten bewirkt, dass das Gradientenmoment des zweiten Teils das Gradientenmoment des ersten Teils aufgrund der unterschiedlichen Polarität zumindest teilweise aufhebt. Folglich kann durch eine entsprechende Wahl des ersten Teils und des zweiten Teils einerseits eine definierte Maxwell-Phase, andererseits ein definiertes Gradientenmoment, insbesondere das Dephasiergradientenmoment realisiert werden. Dabei kann gleichzeitig durch Einhaltung des ersten zeitlichen Abstandes sichergestellt werden, dass der bipolare Gradient keine Anpassung der Echozeit erfordert.

Die Eliminierung der Maxwell-Phase während des Auslesevorgangs, also während des Auslesegradienten verhindert Artefakte wie Ghosting und Signalauslöschungen in den Bilddaten. Zusätzlich kann der bipolare Gradientenpuls derart gewählt sein, dass eine Amplitude des ersten Teils und/oder des zweiten Teils des bipolaren Gradientenpulses minimiert wird und/oder der Betrag der Amplituden des ersten Teils und des zweiten Teils des bipolaren Gradientenpulses gleich groß ist. Die Verwendung eines bipolaren Gradientenpulses auf der Ausleseachse erfordert zudem nur geringe Anstiegs- und Abfallraten der Magnetfeldgradienten. Dies bewirkt eine geringe periphere Nervenstimulation und eine geringe zusätzliche Erwärmung der Gradientenspuleneinheit. Zusätzlich kann das erfindungsgemäße Verfahren auch in Kombination mit weniger performanten und kostengünstigeren Gradientenspuleneinheiten angewendet werden.

Eine Ausführungsform des Verfahrens sieht vor, dass der erste Teil des bipolaren Gradientenpulses die gleiche Polarität wie der Auslesegradient aufweist. Die MR-Steuerungssequenz ist vorzugsweise als TSE basierte MR-Steuerungssequenz ausgebildet. Ein Dephasiergradient weist bei solchen MR-Steuerungssequenzen typischerweise die gleiche Polarität auf wie der Auslesegradient. Der Dephasiergradient und der Auslesegradient wirken entlang der Ausleseachse. Der erste Teil des bipolaren Gradientenpulses weist demnach ein Gradientenmoment auf, welches zumindest dem Dephasiergradientenmoment entspricht. Das Gradientenmoment des zweiten Teils des bipolaren Gradientenpulses wirkt typischerweise dem Gradientenmoment des ersten Teils des bipolaren Gradientenpulses entgegen, sodass das gesamte Gradientenmoment des bipolaren Gradientenpulses dem Dephasiergradientenmoment entspricht. Diese Ausführungsform stellt eine geringe Änderung zu einem herkömmlichen Dephasiergradienten dar und ist demnach robust und leicht implementierbar.

Eine Ausführungsform des Verfahrens sieht vor, dass zwischen genau zwei der zumindest zwei konsekutiven Refokussierungspulse zumindest zwei Auslesegradienten vorgesehen sind und das Dephasiergradientenmoment für den Auslesegradient nur den ersten Auslesegradient der zumindest zwei Auslesegradienten berücksichtigt. Vorzugsweise umfasst die MR-Steuerungssequenz eine Vielzahl an Refokussierungspulsen nach dem Anregungspuls. Die zwei Auslesegradienten unterscheiden sich typischerweise in ihrer Amplitude und/oder in ihrem zeitlichen Abstand zum vorangehenden Refokussierungspuls. Vorzugsweise sind die jeweils zwei Auslesegradienten nach jedem Refokussierungspuls vorgesehen. Die MR-Steuerungssequenz umfasst einen zweiten Dephasierungsgradienten aufweisend ein für den zweiten Auslesegradienten der zumindest zwei Auslesegradienten erforderliches Dephasiergradientenmoment, welcher zweite Dephasierungsgradient nach jedem Refokussierungspuls nach dem zweiten Auslesegradienten vorgesehen ist. Der zweite Dephasierungsgradient kann auch nach jedem Refokussierungspuls zwischen dem ersten Auslesegradienten der zumindest zwei Auslesegradienten und dem zweiten Auslesegradienten der zumindest zwei Auslesegradienten vorgesehen sein. Der zweite Dephasierungsgradient ist typischerweise zum zeitlichen Mittelpunkt zwischen zwei aufeinanderfolgenden Refokussierungspulsen wirksam und/oder in der zeitlichen Mitte zwischen zwei aufeinanderfolgenden Refokusierungspulsen angeordnet. Ohne Verwendung des erfindungsgemäßen bipolaren Gradientenpulses kann die Maxwell-Phase nach jedem Refokusierungspuls, insbesondere bei jedem ersten Auslesegradienten der zumindest zwei Auslesegradienten und bei jedem zweiten Auslesegradienten der zumindest zwei Auslesegradienten, verschieden sein, was zu starken Maxwell-Feldern und Artefakten wie Ghosting und Signalauslöschungen führen kann.

Eine Ausführungsform des Verfahrens sieht vor, dass die MR-Steuerungssequenz als DIXON-Sequenz oder als Turbo-Gradienten-Spin-Echo-Sequenz ausgebildet ist.

Eine derartig ausgebildete MR-Steuerungssequenz ist dadurch gekennzeichnet, dass nach einem Anregungspuls zumindest zwei Refokussierungspulse vorgesehen sind und zwischen zwei benachbarten Refokussierungspulsen zumindest zwei Auslesegradienten vorgesehen sind. Insbesondere bei der DIXON-Sequenz weisen die Auslesegradienten eine überdurchschnittlich hohe Amplitude auf, weshalb eine resultierende erste Maxwell-Phase besonders groß ist. Ohne Verwendung des erfindungsgemäßen bipolaren Gradientenpulses würde der Einfluss der Maxwell-Phase insbesondere auf die MR-Signal mit gegensätzlicher Phase besonders stark sein und Artefakte in resultierenden Fett- und Wasser-Bildern verstärken. Folglich ist die Verwendung des erfindungsgemäßen bipolaren Gradientenpulses in Kombination mit einer DIXON-Sequenz besonders vorteilhaft.

Eine Ausführungsform des Verfahrens sieht vor, dass zwischen dem Anregungspuls und dem ersten der zumindest zwei konsekutiven Refokussierungspulse auf der Ausleseachse des Auslesegradienten nur der bipolare Gradientenpuls vorgesehen ist. Diese Ausführungsform stellt sicher, dass alle für den Verlauf der MR-Steuerungssequenz erforderlichen und bereits vor dem ersten Refokussierungspuls möglichen Vorbereitungen auf der Ausleseachse in den bipolaren Gradientenpuls integriert sind. Folglich kann eine Dauer des bipolaren Gradientenpulses dem ersten zeitlichen Abstand entsprechen und eine Ruhezeit zwischen Anregungspuls und erstem Refokussierungspuls optimal nutzen. Folglich können Amplituden des ersten Teils und des zweiten Teils des bipolaren Gradientenpulses möglichst gering gewählt werden, was auch schnelle und starke Schaltzyklen beim Ausspielen des bipolaren Gradientenpulses vermeidet. Würde ein bipolarer Gradient zur Kompensation einer Maxwell-Phase zusätzlich zu einem für den Auslesegradienten ohnehin vorhandenen Dephasiergradienten eingeführt, so wären im Vergleich zu dieser Ausführungsform höhere Amplituden, mehr Schaltzyklen und stärkere Anstiegs- und Abfallraten der Magnetfeldgradienten erforderlich. Diese Ausführungsform ermöglicht folglich eine besonders effiziente Kompensation der ersten Maxwell-Phase.

Eine Ausführungsform des Verfahrens sieht vor, dass der bipolare Gradientenpuls eine Dauer von mehr als 50% und weniger als 95% des ersten zeitlichen Abstandes aufweist.

Der bipolare Gradientenpuls weist typischerweise eine Dauer von mehr als 60%, bevorzugt mehr als 70%, besonders bevorzugt von mehr als 80% des ersten zeitlichen Abstandes auf.

Der bipolare Gradientenpuls weist typischerweise eine Dauer von weniger als 98%, bevorzugt weniger als 95%, besonders bevorzugt von weniger als 90% des ersten zeitlichen Abstandes auf. Diese Ausführungsform ermöglicht eine besonders gute Ausnutzung des ersten zeitlichen Abstandes. Insbesondere können gemäß dieser Ausführungsform die Amplituden des ersten Teils des bipolaren Gradientenpulses und des zweiten Teils des bipolaren Gradientenpulses reduziert und/oder minimiert werden. Dadurch wird eine Erwärmung und/oder eine periphere Nervenstimulation eines Untersuchungsobjektes reduziert. Insbesondere wird die Ruhezeit auf der Ausleseachse zwischen Anregungspuls und erstem Refokussierungspuls besonders gut ausgenutzt, ohne dass eine Änderung der Echozeit erforderlich ist.

Eine Ausführungsform des Verfahrens sieht vor, dass das Verfahren eine Bereitstellung der MR-Steuerungssequenz gemäß den folgenden Schritten umfasst:

- Bereitstellung des Anregungspulses gefolgt von den zumindest zwei konsekutiven Refokussierungspulsen und dem zumindest einen Auslesegradienten,
- Bereitstellung eines dem Auslesegradient entsprechenden initialen Dephasiergradienten aufweisend das Dephasiergradientenmoment,
- Transformation des initialen Dephasiergradienten zum ersten Teil des bipolaren Gradientenpulses, umfassend eine Änderung einer Amplitude des initialen Dephasiergradienten und eine Änderung einer Dauer des initialen Dephasiergradienten, insbesondere unter Berücksichtigung des ersten zeitlichen Abstandes,

unter der Bedingung, dass eine Maxwell-Phase induziert durch den ersten Teil des bipolaren Gradientenpulses, einer Maxwell-Phase induziert durch den initialen Dephasiergradienten, entspricht.

Der initiale Dephasiergradient ist typischerweise ein Gradientenpuls entlang der Ausleseachse. Der initiale Dephasiergradient weist typischerweise die gleiche Polarität auf wie der Auslesegradient und/oder der erste Teil des bipolaren Gradientenpulses. Die Bereitstellung des initialen Dephasiergradienten kann eine Ermittlung des initialen Dephasiergradienten basierend auf dem Auslesegradient und/oder einem für den Auslesegradient erforderlichen Dephasiergradientenmoment umfassen. Die Bereitstellung der HF-Pulse und/oder des initialen Dephasiergradienten kann im Rahmen einer Bereitstellung einer herkömmlichen MR-Steuerungssequenz erfolgen. Die Änderung der Amplitude des initialen Dephasiergradienten kann eine Reduzierung oder eine Erhöhung der Amplitude umfassen. Die Änderung der Dauer des initialen Dephasiergradienten kann eine Reduzierung oder eine Erhöhung der Dauer umfassen. Eine Reduzierung der Amplitude des initialen Dephasiergradienten hin zum ersten Teil des bipolaren Gradientenpulses unter Beibehaltung der Maxwell-Phase geht typischerweise mit einer Verlängerung der Dauer einher, wobei das Gradientenmoment des ersten Teils des bipolaren Gradientenpulses größer als das Dephasiergradientenmoment wird. Eine Verlängerung der Amplitude des initialen Dephasiergradienten hin zum ersten Teil des bipolaren Gradientenpulses unter Beibehaltung der Maxwell-Phase geht typischerweise mit einer Verkürzung der Dauer einher, wobei das Gradientenmoment des ersten Teils des bipolaren Gradientenpulses kleiner als das Dephasiergradientenmoment wird. Die Ursache liegt in der quadratischen Abhängigkeit der Maxwell-Phase und der linearen Abhängigkeit des Gradientenmomentes von der Amplitude. Diese Ausführungsform ermöglicht eine einfache Generierung des ersten Teils des bipolaren Gradientenpulses.

Eine Ausführungsform des Verfahrens sieht vor, dass die Transformation unter der Bedingung erfolgt, dass das Gradientenmoment des ersten Teils des bipolaren Gradientenpulses dem Dephasiergradientenmoment abzüglich dem Gradientenmoment des zweiten Teils des bipolaren Gradientenpulses entspricht. Diese Ausführungsform stellt sicher, dass der bipolare Gradient das für die Dephasierung des Gradientenmomentes erforderliche Dephasiergradientenmoment aufweist.

Eine Ausführungsform des Verfahrens umfasst zusätzlich

- eine Bereitstellung der ersten Maxwell-Phase, und
- eine Festlegung des zweiten Teils des bipolaren Gradientenpulses, wobei die Maxwell-Phase induziert durch den zweiten Teil des bipolaren Gradientenpulses der Hälfte der ersten Maxwell-Phase abzüglich der Maxwell-Phase des initialen Dephasiergradienten entspricht. Die Bereitstellung der ersten Maxwell-Phase kann eine Bestimmung der ersten Maxwell-Phase basierend auf dem Auslesegradient umfassen.

Diese Ausführungsform stellt sicher, dass der bipolare Gradient eine zur Kompensation der ersten Maxwell-Phase passende Maxwell-Phase aufweist. Zudem ermöglicht diese Ausführungsform eine einfache und robuste Generierung des zweiten Teils des bipolaren Gradientenpulses.

Eine Ausführungsform des Verfahrens sieht vor, dass die Festlegung des zweiten Teils des bipolaren Gradientenpulses unter der Bedingung erfolgt, dass die Dauer des zweiten Teils des bipolaren Gradientenpulses zwischen 50% und 95% des zeitlichen Abstandes zwischen initialem Dephasiergradienten und einem ersten der zumindest zwei konsekutiven Refokussierungspulse entspricht.

Der zeitliche Abstand zwischen dem initialen Dephasiergradienten und dem ersten Refokussierungspuls kann der Dauer zwischen Ende des initialen Dephasiergradienten und Beginn des ersten Refokussierungspulses und/oder Beginn eines den ersten Refokussierungspuls begleitenden Schichtselektionsgradienten entsprechen. Der zeitliche Abstand zwischen dem initialen Dephasiergradienten und dem ersten Refokussierungspuls kann durch den zeitlichen Abstand zwischen dem zeitlichen Mittelpunkt des initialen Dephasiergradienten und dem zeitlichen Mittelpunkt des ersten Refokussierungspulses definiert sein. Die Dauer des zweiten Teils des bipolaren Gradientenpulses beträgt bevorzugt zumindest 60% und/oder höchstens 90%, besonders bevorzugt zumindest 70% und/oder höchstens 80% des zeitlichen Abstandes zwischen initialem Dephasiergradienten und dem ersten Refokussierungspuls. Folglich kann der zweite Teil des bipolaren Gradientenpulses eine Ruhezeit zwischen initialem Dephasiergradienten und erstem Refokussierungspuls optimal nutzen. Eine Änderung der Echozeit wird dabei vermieden.

Die Transformation des initialen Dephasiergradienten zum ersten Teil und/oder die Bestimmung des zweiten Teils des bipolaren Gradientenpulses kann deterministisch unter fixen Randbedingungen, wie beispielsweise einer definierten Dauer des zweiten Teils des bipolaren Gradientenpulses, erfolgen. Die Transformation des initialen Dephasiergradienten zum ersten Teil und/oder die Bestimmung des zweiten Teils des bipolaren Gradientenpulses kann iterativ hinsichtlich eines Optimums, umfassend beispielsweise eine minimale Amplitude des bipolaren Gradientenpulses, erfolgen.

Des Weiteren geht die Erfindung aus von einem Magnetresonanzgerät mit einer Steuerungseinheit umfassend eine Ansteuerungseinheit. Die Ansteuerungseinheit ist dazu ausgebildet, ein erfindungsgemäßes Verfahren zu einer Ansteuerung eines Magnetresonanzgerätes auszuführen.

Dafür weist die Ansteuerungseinheit typischerweise einen Eingang, eine Prozessoreinheit und einen Ausgang auf. Über den Eingang können der Ansteuerungseinheit eine MR-Steuerungseinheit und/oder ein Anregungspuls gefolgt von den zumindest zwei konsekutiven Refokussierungspulsen und dem zumindest einen Auslesegradienten, sowie ein initialer Dephasiergradient und/oder eine erste Maxwell-Phase bereitgestellt werden. Weitere, im Verfahren benötigte Funktionen, Algorithmen oder Parameter können der Ansteuerungseinheit über den Eingang bereitgestellt werden. Der bipolare Gradientenpuls und/oder weitere Ergebnisse einer Ausführungsform des erfindungsgemäßen Verfahrens können über den Ausgang bereitgestellt werden. Die Ansteuerungseinheit kann in das Magnetresonanzgerät integriert sein. Die Ansteuerungseinheit kann auch separat von dem Magnetresonanzgerät installiert sein. Die Ansteuerungseinheit kann mit dem Magnetresonanzgerät verbunden sein.

Das Magnetresonanzgerät umfasst einen Hauptmagneten zu einer Erzeugung eines Hauptmagnetfeldes. Das Hauptmagnetfeld beträgt typischerweise zwischen 0,1 Tesla und 7 Tesla, insbesondere 1,5 Tesla oder 3 Tesla. Das Hauptmagnetfeld ist vorzugsweise geringer als 1,5 Tesla, bevorzugt geringer als 1 Tesla, besonders bevorzugt geringer als 0,8 Tesla. Das Hauptmagnetfeld kann zwischen 0,4 Tesla und 0,7 Tesla, bevorzugt zwischen 0,5 Tesla und 0,6 Tesla betragen. Die erfindungsgemäße Ansteuerung eines solchen Magnetresonanzgerätes ist besonders vorteilhaft, da eine Intensität der Maxwell-Felder invers proportional zu einer Stärke des Hauptmagnetfeldes ist. Folglich entstehen bei einer herkömmlichen Ansteuerung eines Magnetresonanzgerätes umso höhere Wirbelströme aufgrund von Maxwell-Feldern, je niedriger das Hauptmagnetfeld ist. Das erfindungsgemäße Verfahren eliminiert Wirbelströme aufgrund von Maxwell-Feldern, weshalb es bei Magnetresonanzgeräten mit Hauptmagneten aufweisend eine niedrigere Stärke besonders vorteilhaft ist.

Ausführungsformen des erfindungsgemäßen Magnetresonanzgerätes sind analog zu den Ausführungsformen des erfindungsgemäßen Verfahrens ausgebildet. Das Magnetresonanzgerät kann weitere Steuerungskomponenten aufweisen, welche zum Ausführen eines erfindungsgemäßen Verfahrens nötig und/oder vorteilhaft sind. Auch kann das Magnetresonanzgerät dazu ausgebildet sein, Steuerungssignale zu senden und/oder Steuerungssignale zu empfangen und/oder zu verarbeiten, um ein erfindungsgemäßes Verfahren auszuführen. Vorzugsweise ist die Ansteuerungseinheit Teil der Steuerungseinheit des erfindungsgemäßen Magnetresonanzgeräts. Auf einer Speichereinheit der Ansteuerungseinheit können Computerprogramme und weitere Software gespeichert sein, mittels derer die Prozessoreinheit der Ansteuerungseinheit einen Verfahrensablauf eines erfindungsgemäßen Verfahrens automatisch steuert und/oder ausführt.

Ein erfindungsgemäßes Computerprogrammprodukt ist direkt in einer Speichereinheit einer programmierbaren Ansteuerungseinheit ladbar und weist Programmcode-Mittel auf, um ein erfindungsgemäßes Verfahren auszuführen, wenn das Computerprogrammprodukt in der Ansteuerungseinheit ausgeführt wird. Dadurch kann das erfindungsgemäße Verfahren schnell, identisch wiederholbar und robust ausgeführt werden. Das Computerprogrammprodukt ist so konfiguriert, dass es mittels der Ansteuerungseinheit die erfindungsgemäßen Verfahrensschritte ausführen kann. Die Ansteuerungseinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem elektronisch lesbaren Medium gespeichert oder auf einem Netzwerk oder Server hinterlegt, von wo es in den Prozessor einer lokalen Ansteuerungseinheit geladen werden kann, der mit dem Magnetresonanzgerät direkt verbunden oder als Teil des Magnetresonanzgeräts ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Ansteuerungseinheit eines Magnetresonanzgeräts ein erfindungsgemäßes Verfahren durchführen. Beispiele für elektronisch lesbare Datenträger sind eine DVD, ein Magnetband oder einen USB-Stick, auf welchem elektronisch lesbare Steuerinformationen, insbesondere Software, gespeichert ist. Wenn diese Steuerinformationen (Software) von dem Datenträger gelesen und in eine Steuerungseinheit und/oder Ansteuerungseinheit eines Magnetresonanzgeräts gespeichert werden, können alle erfindungsgemäßen Ausführungsformen der vorab beschriebenen Verfahren durchgeführt werden.

Des Weiteren geht die Erfindung aus von einem elektronisch lesbaren Datenträger, auf dem ein Programm hinterlegt ist, das zu einer Ausführung eines Verfahrens zu einer Ansteuerung eines Magnetresonanzgerätes, vorgesehen ist.

Die Vorteile des erfindungsgemäßen Magnetresonanzgeräts, des erfindungsgemäßen Computerprogrammprodukts und des erfindungsgemäßen elektronisch lesbaren Datenträgers entsprechen im Wesentlichen den Vorteilen des erfindungsgemäßen Verfahrens zu einer Ansteuerung eines Magnetresonanzgerätes, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.

Es zeigen:

Fig. 1   ein erfindungsgemäßes Magnetresonanzgerät in einer schematischen Darstellung,

Fig. 2   ein Teildiagramm einer herkömmlichen MR-Steuerungssequenz mit resultierender Maxwell-Phase,

Fig. 3   ein Teildiagramm einer MR-Steuerungssequenz zur Verwendung in einer ersten Ausführungsform eines erfindungsgemäßen Verfahrens,

Fig. 4   ein Teildiagramm einer MR-Steuerungssequenz zur Verwendung in einer zweiten Ausführungsform eines erfindungsgemäßen Verfahrens,

Fig. 5    ein Ablaufdiagramm einer ersten Ausführungsform ei-nes erfindungsgemäßen Verfahrens, und

Fig. 6    ein Ablaufdiagramm einer zweiten Ausführungsform eines erfindungsgemäßen Verfahrens.

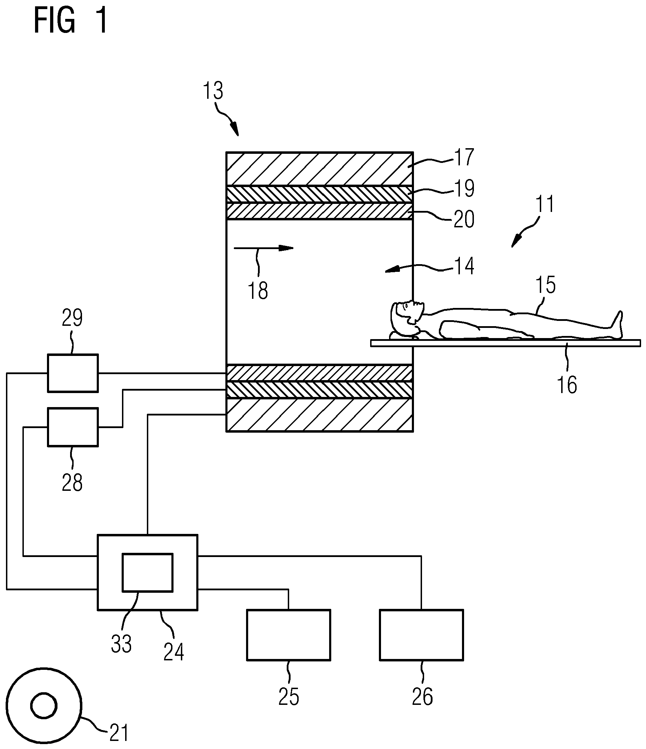

Figur 1 zeigt ein Magnetresonanzgerät 11 zur Ausführung eines erfindungsgemäßen Verfahrens in einer schematischen Darstellung. Das Magnetresonanzgerät 11 umfasst eine von einer Magneteinheit 13 gebildeten Detektoreinheit mit einem Hauptmagneten 17 zu einem Erzeugen eines starken und insbesondere konstanten Hauptmagnetfelds 18. Zudem weist das Magnetresonanzgerät 11 einen zylinderförmigen Patientenaufnahmebereich 14 zu einer Aufnahme eines Untersuchungsobjektes 15 auf, wobei der Patientenaufnahmebereich 14 in einer Umfangsrichtung von der Magneteinheit 13 zylinderförmig umschlossen ist. Das Untersuchungsobjekt 15 kann mittels einer Patientenlagerungsvorrichtung 16 des Magnetresonanzgeräts 11 in den Patientenaufnahmebereich 14 geschoben werden.
Die Magneteinheit 13 weist weiterhin eine Gradientenspuleneinheit 19 auf, die für eine Ortskodierung während einer Bildgebung verwendet wird. Die Gradientenspuleneinheit 19 wird mittels einer Gradientensteuereinheit 28 angesteuert. Des Weiteren weist die Magneteinheit 13 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente HF-Pulse in einen Untersuchungsraum, der im Wesentlichen von dem Patientenaufnahmebereich 14 gebildet ist, ein.
Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.
Die Steuerungseinheit 24 umfasst weiterhin eine Ansteuerungseinheit 33. Die Ansteuerungseinheit 33 ist zudem zu einer Ausführung eines Verfahrens zu einer Ansteuerung des Magnetresonanzgerätes 11 gemäß einer MR-Steuerungssequenz ausgelegt. Die Ansteuerungseinheit 33 ist hierzu mit der Hochfrequenzantennensteuereinheit 29 verbunden und ist insbesondere dazu ausgebildet, eine zeitliche Abfolge und/oder zeitlichen Ablauf von HF-Pulsen, insbesondere umfassend den Anregungspuls 38 und die zumindest zwei Refokussierungspulse 39, an die Hochfrequenzantennensteuereinheit 29 zu übertragen, welche typischerweise zu einer Triggerung einer Ausgabe der HF-Pulse über die Hochfrequenzantenneneinheit 20 ausgebildet ist. Die Ansteuerungseinheit 33 ist hierzu mit der Gradientensteuereinheit 28 verbunden und ist insbesondere dazu ausgebildet, eine zeitliche Abfolge und/oder zeitlichen Ablauf von Gradientenpulsen, insbesondere umfassend den Auslesegradient 41 und den bipolaren Gradient 50, an die Gradientensteuereinheit 28 zu übertragen, welche typischerweise zu einer Triggerung einer Ausgabe der Gradientenpulse über die Gradientenspuleneinheit 19 ausgebildet ist. Die Gradientenpulse und die HF-Pulse wirken typischerweise im Patientenaufnahmebereich 14. Die Ansteuerungseinheit 33 weist Computerprogramme und/oder Software auf, die direkt in einer nicht näher dargestellten Speichereinheit der Ansteuerungseinheit 33 ladbar sind, mit Programmmitteln, um ein Verfahren zu einer Ansteuerung des Magnetresonanzgerätes 11 gemäß einer MR-Steuerungssequenz auszuführen, wenn die Computerprogramme und/oder Software in der Ansteuerungseinheit 33 ausgeführt werden. Die Ansteuerungseinheit 33 weist hierzu einen nicht näher dargestellten Prozessor auf, der zu einer Ausführung der Computerprogramme und/oder Software ausgelegt ist. Alternativ hierzu können die Computerprogramme und/oder Software auch auf einem getrennt von der Steuerungseinheit 24 und/oder Ansteuerungseinheit 33 ausgebildeten elektronisch lesbaren Datenträger 21 gespeichert sein, wobei ein Datenzugriff von der Ansteuerungseinheit 33 auf den elektronisch lesbaren Datenträger 21 über ein Datennetz erfolgen kann.
Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird. Das Magnetresonanzgerät 11 ist somit zusammen mit der Ansteuerungseinheit 33 zur Ausführung eines erfindungsgemäßen Verfahrens ausgelegt.
Ein Verfahren zu einer Ansteuerung des Magnetresonanzgerätes 11 gemäß einer MR-Steuerungssequenz kann auch in Form eines Computerprogrammprodukts vorliegen, das das Verfahren auf die Ansteuerungseinheit 33 implementiert, wenn es auf der Ansteuerungseinheit 33 ausgeführt wird. Ebenso kann ein elektronisch lesbarer Datenträger 21 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des elektronisch lesbaren Datenträgers 21 in einer Ansteuerungseinheit 33 eines Magnetresonanzgeräts 11 das beschriebene Verfahren durchführen.

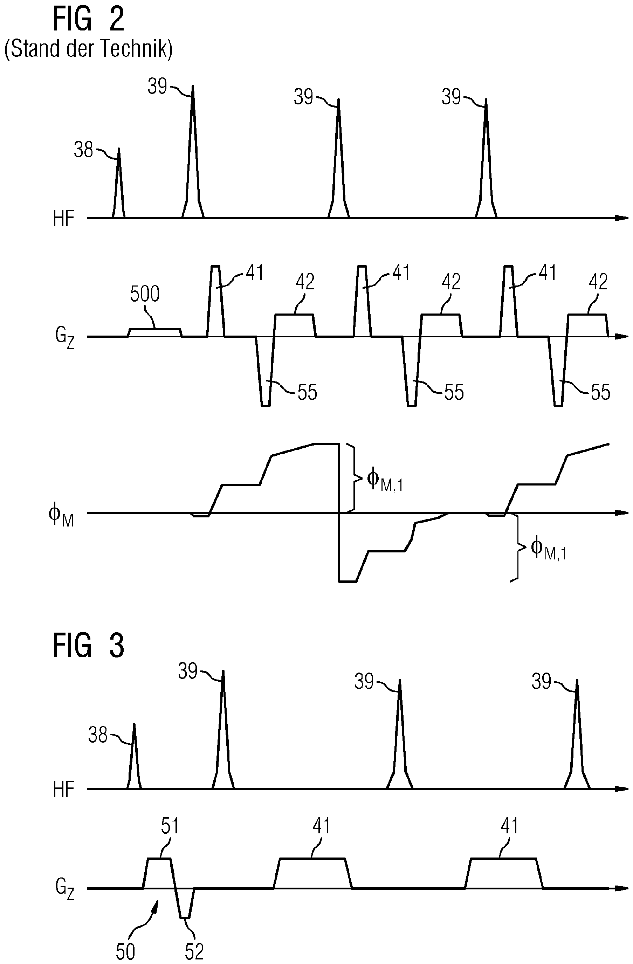

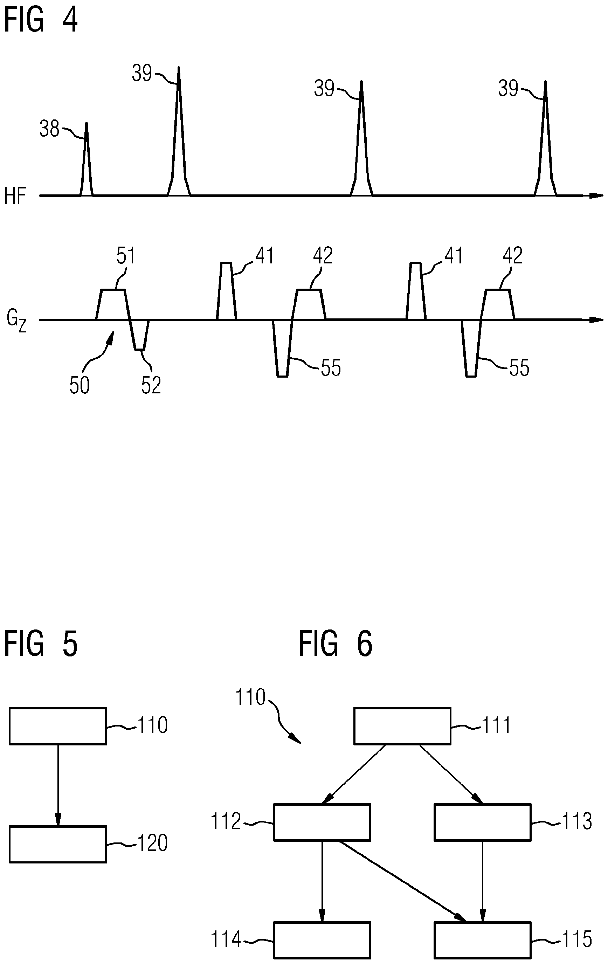

Figur 2 zeigt ein Teildiagramm einer herkömmlichen MR-Steuerungssequenz mit resultierender Maxwell-Phase. Das Teildiagramm umfasst die HF-Pulse (HF) und Gradienten $G_z$ wirkend in Ausleserichtung, also entlang der Ausleseachse, welche hier als z-Richtung bezeichnet, im Zeitverlauf. Auf eine Darstellung der Gradienten wirkend in Phasenkodierrichtung und in Schichtselektionsrichtung wird hier und in den folgenden Figuren 3 und 4 verzichtet. Die herkömmliche MR-Steuerungssequenz umfasst zumindest einen Anregungspuls 38 gefolgt von zumindest zwei konsekutiven Refokussierungspulsen 39. Zwischen zwei aufeinanderfolgenden konsekutiven Refokussierungspulsen 39 wird typischerweise zur Echozeit ein Auslesegradient 41, 55 zur Ortskodierung in Ausleserichtung geschalten. Eine MR-Steuerungssequenz kann auch als DIXON-Sequenz ausgebildet sein und zumindest zwei Auslesegradienten 41, 55 zwischen zwei aufeinanderfolgenden konsekutiven Refokussierungspulsen 39 umfassen. In diesem Fall ist typischerweise ein für den zweiten Auslesegradienten 55 der zumindest zwei Auslesegradienten 41, 55 erforderliche zweite Dephasiergradient 42 ebenso zwischen den zwei aufeinanderfolgenden konsekutiven Refokussierungspulsen 39 angeordnet. Der für den ersten Auslesegradienten 41 der zumindest zwei Auslesegradienten 41, 55 erforderliche herkömmliche, also initiale Dephasiergradient 500 ist typischerweise zwischen Anregungspuls 38 und erstem Refokussierungspuls der zumindest zwei Refokussierungspulse 39 angeordnet.

Der Zeitverlauf der Maxwell-Phase $\Phi_M$, induziert durch die Gradienten $G_z$ wirkend in Ausleserichtung, ist dargestellt. Die erste Maxwell-Phase $\Phi_{M,1}$, jeweils akkumuliert zwischen zwei aufeinanderfolgenden konsekutiven Refokussierungspulsen 39, ist typischerweise für jedes Paar der konsekutiven Refokussierungspulse 39 gleich. Der absolute Betrag der Maxwell-Phase $\Phi_M$ zu den Zeitpunkten der ersten Auslesegradienten 41 unterscheidet sich jedoch im Zeitverlauf der MR-Steuerungssequenz. Ebenso unterscheidet sich der absolute Betrag der Maxwell-Phase $\Phi_M$ zu den Zeitpunkten der zweiten Auslesegradienten 55 im Zeitverlauf der MR-Steuerungssequenz.

Figur 3 zeigt ein Teildiagramm einer MR-Steuerungssequenz zur Verwendung in einer ersten Ausführungsform eines erfindungsgemäßen Verfahrens. Die MR-Steuerungssequenz umfassend einen Anregungspuls 38 gefolgt von zumindest zwei konsekutiven Refokussierungspulsen 39, wobei zwischen genau zwei der zumindest zwei konsekutiven Refokussierungspulsen 39 ein Auslesegradient 41 vorgesehen ist. Die MR-Steuerungssequenz umfasst einen bipolaren Gradientenpuls 50 aufweisend einen ersten Teil 51 und zweiten Teil 52 mit gegensätzlicher Polarität angeordnet zwischen dem Anregungspuls 38 und einem ersten der zumindest zwei konsekutiven Refokussierungspulse 39. Der bipolare Gradientenpuls 50 ist derart ausgestaltet, dass eine Maxwell-Phase $\Phi_M$ induziert durch den bipolaren Gradientenpuls 50 zwischen 40% und 60% der ersten Maxwell-Phase $\Phi_{M,1}$, bevorzugt der Hälfte der ersten Maxwell-Phase $\Phi_{M,1}$, entspricht. Das Gradientenmoment des bipolaren Gradientenpulses 50 entspricht einem Dephasiergradientenmoment für den Auslesegradienten 41. Die Polarität des ersten Teils 51 des bipolaren Gradientenpulses 50 weist dabei die gleiche Polarität wie der Auslesegradient 41 auf. Die Dauer des bipolaren Gradientenpulses 50 entspricht höchstens einem ersten zeitlichen Abstand zwischen dem Anregungspuls 38 und dem ersten Refokussierungspuls der zumindest zwei Refokussierungspulse 39. Vorzugsweise beträgt die Dauer des bipolaren Gradientenpulses 50 zwischen 50% und 95% des ersten zeitlichen Abstandes. Typischerweise ist der bipolare Gradientenpuls 50 der einzige Gradient $G_z$ wirkend in Ausleserichtung angeordnet zwischen dem Anregungspuls 38 und dem ersten Refokussierungspuls der zumindest zwei Refokussierungspulse 39.

Figur 4 zeigt ein Teildiagramm einer MR-Steuerungssequenz zur Verwendung in einer zweiten Ausführungsform eines erfindungsgemäßen Verfahrens. Die zweite Ausführungsform unterscheidet sich von der ersten Ausführungsform darin, dass nicht nur ein Auslesegradient 41, sondern zwei Auslesegradienten 41, 55 zwischen jeweils zwei benachbarten Refokussierungspulsen 39 vorgesehen sind. Der für den zweiten Auslesegradienten 55 erforderliche zweite Dephasiergradient 42 ist ebenso zwischen den zwei aufeinanderfolgenden konsekutiven Refokussierungspulsen 39 angeordnet. Das Gradientenmoment des zweiten Dephasiergradienten 42 entspricht dem für den zweiten Auslesegradienten 55 erforderliche Gradientenmoment, also insbesondere dem halben dem zweiten Auslesegradienten 55 entsprechende Gradientenmoment. Das Gradientenmoment des bipolaren Gradientenpulses 50 entspricht dabei dem Dephasiergradientenmoment für den ersten Auslesegradient 41.

Figur 5 zeigt ein Ablaufdiagramm einer ersten Ausführungsform eines erfindungsgemäßen Verfahrens. Dieses Verfahren umfasst mit Verfahrensschritt 110 die Bereitstellung einer in Figur 3 oder Figur 4 gezeigten MR-Steuerungssequenz. Abschließend erfolgt in Verfahrensschritt 120 die Ansteuerung des Magnetresonanzgerätes 11 gemäß der bereitgestellten MR-Steuerungssequenz.

Figur 6 zeigt ein Ablaufdiagramm einer zweiten Ausführungsform eines erfindungsgemäßen Verfahrens. Verfahrensschritt 110, also die Bereitstellung der MR-Steuerungssequenz kann die folgenden Verfahrensschritte umfassen: Verfahrensschritt 111 umfasst die Bereitstellung des Anregungspulses 38 gefolgt von den zumindest zwei konsekutiven Refokussierungspulsen 39 und dem zumindest einen Auslesegradienten 41, 55. Verfahrensschritt 112 sieht die Bereitstellung eines dem Auslesegradient 41 entsprechenden initialen Dephasiergradienten 500 vor, wobei der initiale Dephasiergradient 500 das für den Auslesegradienten 41 erforderliche Dephasiergradientenmoment aufweist.

Verfahrensschritt 114 umfasst die Transformation des initialen Dephasiergradienten 500 zum ersten Teil 51 des bipolaren Gradientenpulses 50, umfassend eine Reduktion einer Amplitude des initialen Dephasiergradienten 500 und/oder eine Verlängerung einer Dauer des initialen Dephasiergradienten 500, insbesondere unter Berücksichtigung des ersten zeitlichen Abstandes. Dies erfolgt unter den Bedingungen, dass eine Maxwell-Phase induziert durch den ersten Teil 51 des bipolaren Gradientenpulses 50 einer Maxwell-Phase induziert durch den initialen Dephasiergradienten 500 entspricht, und dass das Gradientenmoment des ersten Teils 51 des bipolaren Gradientenpulses 50 dem Dephasiergradientenmoment abzüglich dem Gradientenmoment des zweiten Teils 52 des bipolaren Gradientenpulses 50 entspricht.

Verfahrensschritt 113 umfasst eine Bereitstellung der ersten Maxwell-Phase $\Phi_{M,1}$. Die Bereitstellung der ersten Maxwell-Phase $\Phi_{M,1}$ kann auch eine Bestimmung der ersten Maxwell-Phase $\Phi_{M,1}$ basierend auf dem zumindest einen Auslesegradienten 41 umfassen. In Verfahrensschritt 115 erfolgt eine Festlegung des zweiten Teils 52 des bipolaren Gradientenpulses 50, wobei die Maxwell-Phase induziert durch den zweiten Teil 52 des bipolaren Gradientenpulses 50 der Hälfte der ersten Maxwell-Phase $\Phi_{M,1}$ abzüglich der Maxwell-Phase des initialen Dephasiergradienten 500 entspricht. Hierbei kann die Bedingung gelten, dass die Dauer des zweiten Teils 52 des bipolaren Gradientenpulses 50 zwischen 50% und 95% des zeitlichen Abstandes zwischen initialem Dephasiergradienten 500 und dem ersten Refokussierungspuls der zumindest zwei Refokussierungspulse 39 entspricht.

Diese Ausführungsform kann insbesondere alle hier aufgeführten Verfahrensschritte 111, 112, 113, 114, 115 umfassen. Alternativ kann diese Ausführungsform auch nur die Verfahrensschritte 111, 112, 114 oder die Verfahrensschritte 111, 112, 113, 115 umfassen. Die Ansteuerungseinheit 33 ist typischerweise dazu ausgebildet, die Verfahrensschritte 111, 112, 113, 114, 115, insbesondere auch die Verfahrensschritte 110, 120 auszuführen.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zu einer Ansteuerung eines Magnetresonanzgerätes gemäß einer MR-Steuerungssequenz umfassend zumindest einen Anregungspuls gefolgt von zumindest zwei konsekutiven Refokussierungspulsen,

   wobei zwischen genau zwei der zumindest zwei konsekutiven Refokussierungspulsen alle Magnetfeldgradienten wirkend auf einer Ausleseachse des Auslesegradienten eine erste Maxwell-Phase induzieren und zumindest ein Auslesegradient vorgesehen ist,
   umfassend einen bipolaren Gradientenpuls aufweisend einen ersten Teil und zweiten Teil mit gegensätzlicher Polarität angeordnet zwischen dem Anregungspuls und einem ersten der zumindest zwei konsekutiven Refokussierungspulse,
   wobei

   • eine Maxwell-Phase induziert durch den bipolaren Gradientenpuls zwischen 40% und 60% der ersten Maxwell-Phase entspricht,
   • ein Gradientenmoment des bipolaren Gradientenpulses einem Dephasiergradientenmoment, entsprechend dem Gradientenmoment eines Dephasiergradienten für den Auslesegradient, entspricht, wobei ein Gradientenmoment als Zeitintegral über einen entsprechenden Magnetfeldgradienten definiert ist, und
   • eine Dauer des bipolaren Gradientenpulses höchstens einem ersten zeitlichen Abstand zwischen Anregungspuls und einem ersten der zumindest zwei konsekutiven Refokussierungspulse entspricht.

2. Verfahren nach Anspruch 1,
   wobei der erste Teil des bipolaren Gradientenpulses die gleiche Polarität wie der Auslesegradient aufweist.

3. Verfahren nach einem der vorangehenden Ansprüche,
   wobei die MR-Steuerungssequenz als DIXON-Sequenz oder als Turbo-Gradienten-Spin-Echo-Sequenz ausgebildet ist.

4. Verfahren nach einem der vorangehenden Ansprüche,
   wobei zwischen genau zwei der zumindest zwei konsekutiven Refokussierungspulse zumindest zwei Auslesegradienten vorgesehen sind und das Dephasiergradientenmoment für den Auslesegradient nur den ersten Auslesegradient der zumindest zwei Auslesegradienten berücksichtigt.

**5.** Verfahren nach einem der vorangehenden Ansprüche,
wobei zwischen dem Anregungspuls und dem ersten der zumindest zwei konsekutiven Refokussierungspulse auf der Ausleseachse des Auslesegradienten nur der bipolare Gradientenpuls vorgesehen ist.

**6.** Verfahren nach einem der vorangehenden Ansprüche,
wobei der bipolare Gradientenpuls eine Dauer von mehr als 50% und weniger als 95% des ersten zeitlichen Abstandes aufweist.

**7.** Verfahren nach einem der vorangehenden Ansprüche, umfassend eine Bereitstellung der MR-Steuerungssequenz gemäß den folgenden Schritten:

- Bereitstellung des Anregungspulses gefolgt von den zumindest zwei konsekutiven Refokussierungspulsen und dem zumindest einen Auslesegradienten,
- Bereitstellung eines dem Auslesegradient entsprechenden initialen Dephasiergradienten aufweisend das Dephasiergradientenmoment,
- Transformation des initialen Dephasiergradienten zum ersten Teil des bipolaren Gradientenpulses, umfassend eine Änderung einer Amplitude des initialen Dephasiergradienten und/oder eine Änderung einer Dauer des initialen Dephasiergradienten, insbesondere unter Berücksichtigung des ersten zeitlichen Abstandes,

unter der Bedingung, dass eine Maxwell-Phase induziert durch den ersten Teil des bipolaren Gradientenpulses, einer Maxwell-Phase induziert durch den initialen Dephasiergradienten, entspricht.

**8.** Verfahren nach Anspruch 7,
wobei die Transformation unter der Bedingung erfolgt, dass das Gradientenmoment des ersten Teils des bipolaren Gradientenpulses dem Dephasiergradientenmoment abzüglich dem Gradientenmoment des zweiten Teils des bipolaren Gradientenpulses entspricht.

**9.** Verfahren nach einem der Ansprüche 7 bis 8,
zusätzlich umfassend

- eine Bereitstellung der ersten Maxwell-Phase, und
- eine Festlegung des zweiten Teils des bipolaren Gradientenpulses, wobei die Maxwell-Phase induziert durch den zweiten Teil des bipolaren Gradientenpulses der Hälfte der ersten Maxwell-Phase abzüglich der Maxwell-Phase des initialen Dephasiergradienten entspricht.

**10.** Verfahren nach Anspruch 9,
wobei die Festlegung des zweiten Teils des bipolaren Gradientenpulses unter der Bedingung erfolgt, dass die Dauer des zweiten Teils des bipolaren Gradientenpulses zwischen 50% und 95% des zeitlichen Abstandes zwischen initialem Dephasiergradienten und einem ersten der zumindest zwei konsekutiven Refokussierungspulse entspricht.

**11.** Magnetresonanzgerät mit einer Steuerungseinheit umfassend eine Ansteuerungseinheit, die zu einer Ausführung eines Verfahrens zu einer Ansteuerung des Magnetresonanzgerätes nach einem der vorangehenden Ansprüche ausgelegt ist.

**12.** Computerprogrammprodukt, welches ein Programm umfasst und direkt in einen Speicher einer programmierbaren Ansteuerungseinheit ladbar ist, mit Programmmitteln, um ein Verfahren zu einer Ansteuerung eines Magnetresonanzgerätes nach einem der Ansprüche 1 bis 10 auszuführen, wenn das Programm in der Ansteuerungseinheit ausgeführt wird.

**13.** Elektronisch lesbarer Datenträger, auf dem ein Programm hinterlegt ist, das derart ausgestaltet ist, dass das Programm bei Verwendung des Datenträgers in einer Ansteuerungseinheit das Verfahren zu einer Ansteuerung eines Magnetresonanzgerätes nach einem der Ansprüche 1 bis 10 durchführt.

**Claims**

**1.** Method for actuating a magnetic resonance device according to an MR control sequence comprising at least one excitation pulse followed by at least two consecutive refocusing pulses, wherein, between exactly two of the at least two consecutive refocusing pulses, all magnetic field gradients acting on a readout axis of the readout gradient induce a first Maxwell phase and at least one readout gradient is provided, comprising a bipolar gradient pulse having a first part and a second part of opposite polarity arranged between the excitation pulse and a first of the at least two consecutive refocusing pulses,

wherein

- a Maxwell phase induced by the bipolar gradient pulse corresponds to between 40% and 60% of the first Maxwell phase,
- a gradient moment of the bipolar gradient pulse corresponds to a dephasing gradient moment, corresponding to the gradient moment of a dephasing gradient for the readout gradient, wherein a gradient moment is defined as a time integral over a corresponding magnetic field gradient, and
- a duration of the bipolar gradient pulse corresponds at most to a first time interval between the excitation pulse and a first of the at least two consecutive refocusing pulses.

2. Method according to claim 1,
   wherein the first part of the bipolar gradient pulse has the same polarity as the readout gradient.

3. Method according to one of the preceding claims,
   wherein the MR control sequence is embodied as a DIXON sequence or as a turbo-gradient-spin-echo sequence.

4. Method according to one of the preceding claims,
   wherein at least two readout gradients are provided between exactly two of the at least two consecutive refocusing pulses and the dephasing gradient moment for the readout gradient only takes account of the first readout gradient of the at least two readout gradients.

5. Method according to one of the preceding claims,
   wherein only the bipolar gradient pulse is provided between the excitation pulse and the first of the at least two consecutive refocusing pulses on the readout axis of the readout gradient.

6. Method according to one of the preceding claims,
   wherein the bipolar gradient pulse has a duration greater than 50% and less than 95% of the first time interval.

7. Method according to one of the preceding claims, comprising provision of the MR control sequence according to the following steps:

   - providing the excitation pulse followed by the at least two consecutive refocusing pulses and the at least one readout gradient,
   - providing an initial dephasing gradient corresponding to the readout gradient having the dephasing gradient moment,
   - transforming the initial dephasing gradient to the first part of the bipolar gradient pulse, comprising changing an amplitude of the initial dephasing gradient and/or changing a duration of the initial dephasing gradient, in particular taking account of the first time interval,

   under the condition that a Maxwell phase induced by the first part of the bipolar gradient pulse corresponds to a Maxwell phase induced by the initial dephasing gradient.

8. Method according to claim 7,
   wherein the transformation takes place under the condition that the gradient moment of the first part of the bipolar gradient pulse corresponds to the dephasing gradient moment minus the gradient moment of the second part of the bipolar gradient pulse.

9. Method according to one of claims 7 to 8,

   additionally comprising

   - providing the first Maxwell phase, and
   - defining the second part of the bipolar gradient pulse,

wherein the Maxwell phase induced by the second part of the bipolar gradient pulse corresponds to half the first Maxwell phase minus the Maxwell phase of the initial dephasing gradient.

10. Method according to claim 9,
    wherein the definition of the second part of the bipolar gradient pulse takes place under the condition that the duration of the second part of the bipolar gradient pulse corresponds to between 50% and 95% of the time interval between the initial dephasing gradient and a first of the at least two consecutive refocusing pulses.

11. Magnetic resonance device with a control unit comprising an actuating unit configured to execute a method for actuating the magnetic resonance device according to one of the preceding claims.

12. Computer program product, which comprises a program and can be loaded directly into a memory of a programmable actuating unit, with program means for executing a method for actuating a magnetic resonance device according to one of claims 1 to 10 when the program is executed in the actuating unit.

13. Electronically readable data carrier on which a program is stored, which is embodied in such a way that the program performs the method for actuating a magnetic resonance device according to one of claims 1 to 10 when the data carrier is used in an actuating unit.

**Revendications**

1. Procédé d'excitation d'un appareil à résonnance magnétique suivant une séquence de commande RM comprenant au moins une impulsion d'excitation suivie d'au moins deux impulsions consécutives de refocalisation,

   dans lequel, entre exactement deux des au moins deux impulsions consécutives de refocalisation, tous les gradients de champ magnétique agissant sur un axe de lecture du gradient de lecture induisent une première phase de Maxwell et il est prévu au moins un gradient de lecture,
   comprenant une impulsion de gradient bipolaire, comportant une première partie et une deuxième partie de polarité opposée, disposée entre l'impulsion d'excitation et une première des au moins deux impulsions consécutives de refocalisation,
   dans lequel

   • une phase de Maxwell induite par l'impulsion de gradient bipolaire représente entre 40 % et 60 % de la première phase de Maxwell,
   • un moment de gradient de l'impulsion de gradient bipolaire correspond à un moment de gradient de déphasage correspondant au moment de gradient d'un gradient de déphasage pour le gradient de lecture, dans lequel un moment de gradient est défini comme l'intégral en fonction du temps sur un gradient de champ magnétique correspondant, et
   • une durée de l'impulsion de gradient bipolaire correspond au plus à une première distance dans le temps entre l'impulsion d'excitation et une première des au moins deux impulsions consécutives de refocalisation.

2. Procédé suivant la revendication 1,
   dans lequel la première partie de l'impulsion de gradient bipolaire a la même polarité que le gradient de lecture.

3. Procédé suivant l'une des revendications précédentes,
   dans lequel la séquence de commande RM est constituée sous la forme d'une séquence DIXON ou sous la forme d'une séquence à écho de spin de turbo-gradient.

4. Procédé suivant l'une des revendications précédentes,
   dans lequel, entre exactement deux des au moins deux impulsions consécutives de refocalisation, il est prévu au moins deux gradients de lecture et le moment de gradient de déphasage ne prend en compte, pour le gradient de lecture, que le premier gradient de lecture des au moins deux gradients de lecture.

5. Procédé suivant l'une des revendications précédentes,
   dans lequel il est prévu, entre l'impulsion d'excitation et la première des au moins deux impulsions consécutives de refocalisation, seulement l'impulsion de gradient bipolaire sur l'axe de lecture du gradient de lecture.

**6.** Procédé suivant l'une des revendications précédentes,
dans lequel l'impulsion de gradient bipolaire a une durée représentant plus de 50 % et moins de 95 % de la première distance dans le temps.

**7.** Procédé suivant l'une des revendications précédentes, comprenant une mise en place de la séquence de commande RM selon les stades suivants :

- mise en place de l'impulsion d'excitation suivie des au moins deux impulsions consécutives de refocalisation et du au moins un gradient de lecture,
- mise en place d'un gradient de déphasage initial correspondant au gradient de lecture et comportant le moment de gradient de déphasage,
- transformation du gradient de déphasage initial en la première partie de l'impulsion de gradient bipolaire, comprenant une modification d'une amplitude du gradient de déphasage initial et/ou une modification d'une durée du gradient de déphasage initial, en tenant compte en particulier de la première distance dans le temps,

à la condition qu'une phase de Maxwell induite par la première partie de l'impulsion de gradient bipolaire corresponde à une phase de Maxwell induite par le gradient de déphasage initial.

**8.** Procédé suivant la revendication 7,
dans lequel la transformation s'effectue à la condition que le moment de gradient de la première partie de l'impulsion de gradient bipolaire corresponde au moment de gradient de déphasage diminué du moment de gradient de la deuxième partie de l'impulsion de gradient bipolaire.

**9.** Procédé suivant l'une des revendications 7 à 8,
comprenant en outre

- une mise en place de la première phase de Maxwell, et
- une fixation de la deuxième partie de l'impulsion de gradient bipolaire, la phase de Maxwell induite par la deuxième partie de l'impulsion de gradient bipolaire correspondant à la moitié de la première phase de Maxwell diminuée de la phase de Maxwell du gradient de déphasage initial.

**10.** Procédé suivant la revendication 9,
dans lequel la fixation de la deuxième partie de l'impulsion de gradient bipolaire s'effectue à la condition que la durée de la deuxième partie de l'impulsion de gradient bipolaire représente entre 50 % et 95 % de la distance dans le temps entre le gradient de déphasage initial et une première des au moins deux impulsions consécutives de refocalisation.

**11.** Appareil à résonnance magnétique comprenant une unité de commande, comportant une unité d'excitation, qui est conçue pour une réalisation d'un procédé d'excitation de l'appareil à résonnance magnétique suivant l'une des revendications précédentes.

**12.** Produit de programme d'ordinateur, qui comprend un programme et qui peut être chargé directement dans une mémoire d'une unité d'excitation programmable, comprenant des moyens de programme pour exécuter un procédé d'excitation d'un appareil à résonnance magnétique suivant l'une des revendications 1 à 10, lorsque le programme est réalisé dans l'unité d'excitation.

**13.** Support de données, déchiffrable électroniquement, sur lequel est mis un programme, qui est conformé de manière à ce que le programme, en utilisant le support de données dans une unité d'excitation, exécute le procédé d'excitation d'un appareil à résonnance magnétique suivant l'une des revendications 1 à 10.

FIG 1

## FIG 2
(Stand der Technik)

HF $\quad$ 38 $\quad$ 39 $\quad$ 39 $\quad$ 39

$G_Z$ $\quad$ 500 $\quad$ 41 $\quad$ 42 $\quad$ 41 $\quad$ 42 $\quad$ 41 $\quad$ 42 $\quad$ 55 $\quad$ 55 $\quad$ 55

$\phi_M$ $\quad$ $\phi_{M,1}$ $\quad$ $\phi_{M,1}$

## FIG 3

HF $\quad$ 38 $\quad$ 39 $\quad$ 39 $\quad$ 39

$G_Z$ $\quad$ 51 $\quad$ 41 $\quad$ 41 $\quad$ 50 $\quad$ 52

FIG 4

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **BERNSTEIN et al.** Concomitant Gradient Terms in Phase Contrast MR: Analysis and Correction. *MRM,* 1998, 39300-308

- **ZHOU X. J et al.** Artifacts induced by concomitant magnetic field in fast spin-echo imaging. *MRM,* 1998, vol. 40 (4), 582-591